# EUROPÄISCHE PATENTSCHRIFT

(11) **EP 0 815 579 B1**
(45) Veröffentlichungstag und Bekanntmachung des Hinweises auf die Patenterteilung: **05.11.2003**
(21) Anmeldenummer: 97902195.3
(22) Anmeldetag: 21.01.1997
(51) Int. Cl.: H01J 9/227, H01J 29/28, G03F 7/039, G03F 7/038

(54) **BLACK-MATRIX IN FARBBILDRÖHREN UND VERFAHREN ZUR HERSTELLUNG DER BLACK-MATRIX**
BLACK MATRIX IN COLOUR PICTURE TUBES AND METHOD OF PRODUCING THE BLACK MATRIX
MATRICE NOIRE (BLACK MATRIX) POUR TUBES IMAGE COULEUR ET SON PROCEDE DE PRODUCTION

(30) Priorität: 24.01.1996 DE 19604025; 19.04.1996 DE 19617118
(43) Veröffentlichungstag der Anmeldung: 07.01.1998
(73) Patentinhaber: Samsung Display Devices Co., Ltd., Suwon-City, Kyungki-do 445-970 (KR)
(72) Erfinder: WILPERT, André, D-10119 Berlin (DE); GRÜTZNER, Gabi, D-12689 Berlin (DE); SCHULZE-MATTHÄI, Kerstin, D-12689 Berlin (DE); BENDIG, Jürgen, D-10369 Berlin (DE); TÜMMEL, Klaus, D-12555 Berlin (DE)
(74) Vertreter: Gulde, Klaus W., Dipl.-Chem.
(86) Internationale Anmeldenummer: EP9700268
(87) Internationale Veröffentlichungsnummer: WO97027608

(56) Entgegenhaltungen:
- EP-A- 0 077 976
- EP-A- 0 091 163
- EP-A- 0 483 693
- US-A- 4 273 842
- US-A- 4 590 138
- PATENT ABSTRACTS OF JAPAN vol. 096, no. 002, 29.Februar 1996 & JP 07 261015 A (SUMITOMO CHEM CO LTD), 13.Oktober 1995,

## Beschreibung

Die Erfindung bezieht sich auf eine Black-Matrix in Farbbildröhren, auf eine Positiv-Photoresist-Zusammensetzung, auf ein Mittel zum Schutz einer lichtabsorbierenden Matrix sowie auf ein Verfahren zu Herstellung der Black-Matrix.

Die auf die innere Glasoberfläche von Farbbildröhren aufgebrachte Black-Matrix verbessert das Kontrastverhalten von Farbfernsehbildern. Diese auch als Black-Matrix-Röhren bezeichneten Farbbildröhren weisen auf der inneren Oberfläche eine streifenförmige Struktur auf, die dadurch gekennzeichnet ist, daß lichtabsorbierende Streifen mit lichtdurchlässigen Streifen abwechseln. In der Regel sind diese Streifen vom Standpunkt des Betrachters aus gesehen vertikal angeordnet. Die Breite der absorbierenden und der durchlässigen Streifen liegt in der Größenordnung von 150 bis 190 µm.

Bisher erfolgte das Erzeugen dieser Matrix in einem mehrstufigen Prozeß unter Verwendung von Negativ-Photoresist-Materialien. Diese Negativ-Photoresist-Materialien wurden auf die Innenfläche der Bildröhre aufgetragen und getrocknet. Danach erfolgte mittels einer Maske eine Streifenbelichtung und ein Entwicklungsprozeß, wonach die nicht belichteten Negativ-Photoresist-Streifen zurückblieben. Anschließend erfolgte das Auftragen einer kolloidalen Suspension von Ruß oder Graphit auf die Innenfläche der Farbbildröhre.
In einem weiteren Verfahrensschritt wurden nun die noch vorhandenen Negativ-Photoresist-Streifen mit dem Graphit- bzw. Rußüberzug weggelöst, so daß am Ende dieses Verfahrens streifenförmige Ruß- bzw. Graphitschichten abwechselnd mit lichtdurchlässigen Streifen entstanden.

Dieses Zweistufen-Verfahren (Negativ-Positiv-Verfahren) ist technologisch sehr aufwendig. Es erfordert die Bereitstellung sowohl eines Photoresists als auch einer Graphit- bzw. Ruß-Dispersion. Die relativ große Anzahl von einzelnen Verfahrensschritten, die insbesondere die Randbereiche der Streifen beeinflussen können, kann außerdem zu Unschärfeerscheinungen in den Randbereichen der Streifen führen.

In der EP 91 163 ist eine positiv arbeitende Zusammensetzung beschrieben, die zur Herstellung einer lichtabsorbierenden Matrix in Farbbildröhren eingesetzt wird. Diese positiv arbeitende Photoresist-Zusammensetzung besteht im wesentlichen aus hydrolsiertem Polyvinylalkohol, Ammoniumtrioxalatoferrat, Ferrinitrat und fein verteiltem Graphit oder Ruß, wobei die genannten Bestandteile in Wasser dispergiert sind. Diese Suspension wird auf die innere Oberfläche des Bildschirmes der Farbbildröhre aufgetragen, getrocknet und entsprechend der geforderten Struktur einer UV-Strahlung ausgesetzt.

In der DE 3142261 A1 ist ein Verfahren zur Erzeugung einer Schwarzmatrixschicht zwischen den Leuchtflächen auf der Innenseite der Wannen von Farbbildröhren angegeben. Auch hier wird auf die Innenseite des Bildschirmes nach vorheriger Reinigung ein photoempfindlicher Lack (Positiv-Resist) aufgebracht. Dieser Lack enthält als filmbildende Bestandteile Polyvinylalkohol und Polymethylacrylat und einen Dichromatsensibilisator, wobei als Schwarzpigment Graphit enthalten ist. Nach entsprechender Belichtung und Entwicklung werden die belichteten Teile komplett entfernt, so daß sich ein Positivbild der Schwarzmatrixschicht ausbildet.

Da diese Photoresist-Zusammensetzungen positiv arbeiten, reicht es aus, in einem anschließenden Entwicklungsprozeß die durch die Belichtung wasserlöslich gemachten Bereiche von der Oberfläche abzulösen.

Wie sich jedoch zeigte, haben die bekannten Positiv-Photoresist-Zusammensetzungen, die zur Herstellung einer Black-Matrix verwendet werden verschiedene Nachteile. Die Löslichkeitsdifferenz zwischen den auf der Glasoberfläche verbleibenden lichtabsorbierenden Teilen und den abzulösenden Bereichen ist gering, so daß auch ein Abtrag der unbelichteten Schichtbereiche zu beobachten ist, was zu einer Verschlechterung der absorbierenden Eigenschaften und der Kantenschärfe der Black-Matrix führt. Diese relativ geringe Löslichkeitsdifferenzierung verschlechtert sich noch weiter, wenn nicht darauf geachtet wird, daß während des gesamten Prozesses kein Außenlicht eindringt.

Der Erfindung liegt nun die Aufgabe zugrunde, eine Black-Matrix anzubieten, die mittels einer Positiv-Photoresist-Zusammensetzung hergestellt wird, welche eine gute Strukturierbarkeit zwischen belichteten und unbelichteten Bereichen ermöglicht, und das Verfahren zur Herstellung der Black-Matrix auf wenige technologische Schritte zu verringern.

Die Lösung der Aufgabe erfolgt mit den Merkmalen der Ansprüche 1 und 35.

Weiterbildungen der Erfindung sind in den Unteransprüchen beschrieben.

Die Erfindung weist verschiedene Vorteile auf.

So ist es möglich, die Anzahl der technologischen Schritte bei der Herstellung einer sogenannten Black-Matrix bedeutend zu verringern. Hinzu kommt, daß mit der erfindungsgemäßen Positiv-Photoresist-Zusammensetzung und der gegenwärtigen Prozeßtechnologie eine gute Kompatibilität erreicht wird. Die Matrix weist eine ausgezeichnete Kantenschärfe und hohe optische Dichte auf. Die Strukturqualität zwischen den belichteten und unbelichteten Teilen der Matrix ist hervorragend. Eine aufgebrachte Schutzschicht verhindert, daß im Verlaufe der weiteren Herstellung der Black-Matrix-Röhren die Schwarzstreifen der Matrix aufgrund von photochemischen Reaktionen, die die lichtabsorbierende Wirkung beeinträchtigen könnten, in der Qualität beeinflußt oder zerstört werden.

Die Weiterbildung gemäß Anspruch 14 ist vorteilhaft. Es hat sich gezeigt, daß das in der Zusammensetzung eingesetzte Polyhydroxystyrol eine sehr gute Schichtbildungseigenschaft aufweist. Durch Überführung in das tert.-Butyloxycarbonylpolyhydroxystyrol (Boc-PHS) entsprechend der Weiterbildung der Erfindung gemäß Anspruch 19, das praktisch wasserunlöslich ist, wird es als wäßrige Suspension eingesetzt. Da das Boc-Polyhydroxystyrol säureempfindlich ist, ist es möglich, durch Zusatz von Photoinitiatoren auf der Basis von Oniumsalzen unter dem Einfluß einer UV-Bestrahlung aufgrund der Säurefreisetzung eine Abspaltung der Boc-Gruppe zu erreichen, so daß das Polyhydroxystyrol wieder eine gewisse Löslichkeit in Wasser erlangt. Um den Reaktionsablauf der säurekatalysierten Abspaltung der Boc-Gruppe nicht zu unterbrechen, ist es notwendig die Positiv-Photoresist-Zusammensetzung auf einen pH-Wert um den Neutralpunkt zu halten. Voraussetzung für das Funktionieren der Zusammensetzung ist deshalb die ständige Kontrolle des pH-Wertes sowohl bei der Herstellung als auch der Anwendung im technologischen Prozeß.

Zur Positiv-Strukturierung der lichtabsorbierenden Matrix werden erfindungsgemäß Verbindungen vorgeschlagen, die bei Belichtung im Wellenlängenbereich von 250 bis 450 nm Gase freigeben.

Durch Nachschalten eines geeigneten Entwicklungsschrittes wird so die notwendige Strukturierung der Matrix erreicht. Der Effekt kann durch zusätzlich bei der UV-Belichtung auftretende Löslichkeitsveränderung verstärkt werden.

Zur Erreichung der Effekte können sowohl lichtempfindliche Polymere als auch Polymere in Kombination mit lichtempfindlichen Komponenten eingesetzt werden.

Es werden erfindungsgemäß Verbindungen vorgeschlagen, die aufgrund der Lichteinwirkung Stickstoff, Kohlendioxid, Kohlenwasserstoffe, Sauerstoff oder Aldehyd abspalten.

Zu den Stickstoff freisetzenden Verbindungen zählen vor allem die Azide und Bisazide wie 4,4'-Diazidostilben-2,2'-disulfonsäure oder ihre Salze, p-Nitrophenylazid, Acylazide wie Naphthoylazid, die Diazide wie Benzochinondiazide, Naphthochinondiazide, die Azo- bzw. Diazoverbindungen wie Azobisisobutyronitril, Phenylazotriphenylmethan N,N'-Azocarbazol, die Heterocyclen, die mindestens 2 benachbarte Stickstoffatome enthalten wie z.B. Triazole, Tetrazole, Sydnone, Triazolone und Thiadiazole, die Diazirine wie z.B. Cyclohexan-diazirin und auch Diazoniumsalze, z.B. substituierte Benzoldiazoniumsalze.

Als vorteilhaft einzusetzende CO₂ abspaltende Verbindungen sind zu nennen die Dioxazolone oder Oxazolone wie z.B. 2-Oxo-5-(2,4,6-trimethyl-phenyl)-1,3,4-dioxazol, die Carbonpersäuren oder deren Ester wie z.B. Peressigsäure-tert-butyl-ester, die Diacylperoxiden wie z.B. Dibenzoylperoxid und Phthaldioyl-peroxid, die photodecarboxylierbaren Carbonsäuren wie z.B. Phenylmercaptoessigsäure und Pyridylessigsäure und die Kohlensäureester und Kohlensäurederivate wie z.B. tert.-Butoxycarbonyloxyaromaten.

Als Sauerstoff freisetzende Verbindungen sind die Hydroperoxide und Peroxide zu nennen wie z.B. tert.-Butylhydroperoxid, Di-tert.-Butylperoxid und Anthracenendoperoxid, die Dioxetane wie z.B. Adamantan-dioxetanadamantan und Ozonide.

Als unter Lichteinwirkung Aldehyd freisetzende Verbindungen sind insbesondere Polyoxymethylene oder die entsprechenden Copolymere oder Co-Kondensate geeignet.

Als Kohlenwasserstoff freisetzende Substanzen sind Kohlensäure-Alkyl-Arylester insbesondere Tertiär-Butoxycarbonyloxyphenole anwendbar.

Die Positiv-Photoresist-Zusammensetzung liegt, da sie unlösliche Verbindungen und auch schwarze Pigmente enthält, in der Regel als Suspension vor und wird auch in dieser Form für das Auftragen der Schicht auf die Schirminnenseite eingesetzt. Als besonders vorteilhaft hat sich als Suspensionsmittel Wasser herausgestellt. Jedoch ist es möglich, daß das Wasser in Mischung mit organischen Lösungsmitteln oder rein organische Lösungsmittel eingesetzt wird. Hierzu eignen sich insbesondere wasserlösliche Alkohole und Ester sowie mehrwertige Alkohole und ihre Ester aber auch wasserlösliche Ketone wie z.B. Aceton.

Vorteilhafterweise enthält die Positiv-Photoresist-Zusammensetzung suspensionsstabilisierende und/oder haftvermittelnde Zusätze.

Aufgrund des Gehaltes an suspendiertem Polymer und schwarzem Pigment ist es erforderlich, grenzflächenaktive Stoffe zuzusetzen, die verhindern, daß die sehr kleinen Polymer- und Pigmentteilchen sich zu größeren Aggregaten zusammenlagern und damit die Stabilität der Suspension einschränken. In der Regel werden an sich bekannte Stabilisatoren aus dem Bereich der ionischen und nichtionischen grenzflächenaktiven Stoffe zugesetzt.

Die weiterhin enthaltenen, benetzungsfördernden Zusätze sind an sich bekannt und werden ebenfalls aus der Gruppe der nichtionischen und ionischen grenzflächenaktiven Stoffe ausgewählt.

Da vorgesehen ist, die erfindungsgemäße Positiv-Photoresist-Zusammensetzung zur Bildung einer lichtabsorbierenden Matrix auf die innere Glasoberfläche eines Bildschirmkörpers aufzutragen, ist es zweckmäßig, dem Photoresist haftvermittelnde Substanzen zuzusetzen, die in der Lage sind, zwischen der erfindungsgemäßen Suspension und der Glasoberfläche eine ausreichend feste Verbindung insbesondere nach dem Trocknen zu ermöglichen. Dazu eignen sich vorteilhafterweise die an sich bekannten Alkoxysilane, wie z.B. N-(β-Aminoethyl)-γ-aminopropyl-trimethoxysilan.

Die suspensionsstabilisierenden und benetzungsfördernden sowie die haftvermittelnden Zusätze sind in sehr geringen Konzentrationen in der erfindunsgemäßen Positiv-Photoresist-Zusammensetzung enthalten. Die Konzentration der suspensionsstabilisierenden, grenzflächenaktiven Stoffe hängt im wesentlichen von der Größe der schwarzen Pigmentteilchen und von ihrer Konzentration ab.

Der unbelichtete Positiv-Photoresist, der die lichtabsorbierende Matrix auf der Schirminnenseite bildet, liegt noch mit voller Reaktivität vor. Da im weiteren Verlauf der Herstellung der Farbbildröhren weitere UV-Belichtungen, z.B. während der nachfolgenden Leuchtstoffstreifenherstellung, und Temperaturprozesse für die Trocknung notwendig sind, kann der durch die UV-Belichtung löslich gemachte Positiv-Photoresist durch nachfolgende Wassereinwirkung im Zusammenhang mit der Leuchtstoffstreifenentwicklung eine Zerstörung der Matrixstruktur hervorrufen. Deshalb wird erfindungsgemäß nach Entwicklung und Trocknung der lichtabsorbierenden Matrix zur endgültigen Herstellung der Black-Matrix eine wasserunlösliche Schutzschicht aufgebracht. Das erfolgt erfindungsgemäß mit einem Mittel zum Schutz einer Matrix, das vom Wesen her ein Photoresist ist. Nach Auftragen dieser Schicht auf die Schwarzstreifen unter vollständigem Bedecken wird das erfindungsgemäße Mittel durch UV-Belichtung wasserunlöslich gemacht und damit ein Abtragen der Schwarzstreifen verhindert.

Durch Veränderung der Konzentration der Inhaltstoffe des erfindungsgemäßen Mittels sind Anpassungen an Viskosität, Schichtdicke und Empfindlichkeit sowie Belichtungszeit jederzeit möglich. Die Photohärtung des aufgetragenen Mittels erfolgt durch UV-Licht im Bereich 300 bis 450 nm, durch gleichmäßige Belichtung der gesamten mit diesem Mittel bedeckten Innenfläche des Schirmteils. Die so erzeugte Schutzschicht bedeckt vollständig die Matrixstrukturen und schützt sie gegen den Einfluß der zur Leuchtstoffschichterzeugung verwendeten Flüssigkeiten und Suspensionen, die normalerweise eine Veränderung bzw. Zerstörung der Matrixstrukur im weiteren Prozess der Schirmherstellung hervorrufen könnten.

Das erfindungsgemäße Verfahren zur Herstellung einer Black-Matrix in Farbbildröhren ist durch folgende Teilschritte zusammenfassend gekennzeichnet:
- Beschichtung der inneren Bildschirmfläche mit dem erfindungsgemäßen Fotoresist durch Auf schleudern, Aufsprühen oder andere geeignete Verfahren.
- Trocknung der Resistschicht durch Infrarotstrahlung.
- Gegebenenfalls Vorbelichtung der gesamten aufgebrachten, getrockneten Resistschicht mit UV im Bereich 300 - 450 nm bei Anwendung von Hg-Hochdruckoder Xenon Hochdrucklampen.
- Gegebenenfalls Durchführung eines Postbake-Prozesses der Resistschicht.
- Entwicklung der Matrixstruktur mit Wasser mit einem pH Wert von 7 - 12, wobei die Entwicklungstemperatur bis zu 80°C betragen kann. Während des Entwicklungsprozesses wird die Entwicklerlösung gleichmäßig auf die Innenseite des Bildschirmes aufgebracht, durch Rotation des Schirmteils verteilt und abgeschleudert.
- Trocknung der entstandenen Matrix mittels Infrarotstrahler und/oder Luftspülung mit temperierter Luft.
- Aufbringen einer Schutzschicht durch Aufschleudern, Trocknung und UV-Belichtung

Die Erfindung wird anhand der vorliegenden Ausführungsbeispiele näher erläutert. Die Beispiele 1-7 zeigen dabei das Auftragen der lichtabsorbierenden Matrix, die Beispiele 8 und 9 das Aufbringen der Schutzschicht.

### Beispiel 1

50g einer Graphitsuspension mit einem Feststoffgehalt von 10 Gewichts-% werden unter Rühren mit 0,4g Diphenyliodonium-tetrafluoroborat vermischt und mit einer wäßrigen 1%-igen Lösung von p-Toluolsulfonsäure auf pH-Wert 7 ± 0,5 titriert. Anschließend werden unter starkem Rühren und/oder in einem Ultraschallbad 61g einer wäßrigen Suspension mit einem Feststoffgehalt von 14,3 Gewichts-% an hydrophilisiertem Poly(phydroxylstyrol-Boc) mit einem Boc-Grad von ca. 98% zugegeben und die Mischung homogenisiert. Mit dem so erhaltenen schwarz pigmentierten Photoresist werden homogene Schichten auf der inneren Bildschirmseite einer Farbbildröhre mit einer Schichtdicke von 1,2 µm hergestellt. Die Schichten werden 1 min bei 60°C getrocknet, anschließend erfolgt die Belichtung mit einer Quecksilberhöchstdrucklampe (HBO 500) bei 2 - 5 mJ/cm². Die belichteten Schichten werden 30 sec mit 60°C heißem Wasser entwickelt. Anschließend werden die strukturiert beschichteten Substrate trockengeschleudert.

### Beispiel 2

25 g einer Graphitsuspension mit einem Feststoffgehalt von 10 Gewichts-% werden unter Rühren mit 0,2 g Triphenylsulfonium-hexafluoroantimonat vermischt und mit einer wäßrigen 1%-igen Lösung von p-Toluolsulfonsäure auf pH-Wert 7 ^{±} 0,5 titriert. Anschließend werden unter starkem Rühren und/oder in einem Ultraschallbad 30 g einer wäßrigen Suspension mit einem Feststoffgehalt von 14,3 Gewichts-% an hydrophilisiertem Poly- (p-hydroxystyrol-Boc) mit einem Boc-Grad von ca. 98% zugegeben und die Mischung homogenisiert. Mit dem so erhaltenen schwarz pigmentierten Photoresist werden homogene Schichten auf der inneren Bildschirmseite einer Farbbildröhre mit einer Schichtdicke von 1,3 µm hergestellt. Die Schichten werden 1 min bei 60°C getrocknet, anschließend erfolgt die Belichtung mit einer Quecksilberhöchstdrucklampe (HBO 500) bei 2 - 5 mJ/cm². Die belichteten Schichten werden 25 sec mit 60°C heißem Wasser entwickelt. Anschließend werden die strukturiert beschichteten Substrate trocken geschleudert.

### Beispiel 3

40 g einer Graphitsuspension mit einem Feststoffgehalt von 10 Gewichts-% werden unter Rühren mit 2,3 g einer 1%igen Lösung eines Oniumsalz-Photoinitiators vermischt und mit einer wäßrigen 1%igen Lösung von p-Toluolsulfonsäure auf pH-Wert 7 ± 0,5 titriert. Anschließend werden unter starkem Rühren und/oder in einem Ultraschallbad 49 g einer wäßrigen Suspension mit einem Feststoffgehalt von 14,3 Gewichts-% an hydrophilisiertem Poly-(p-hydroxystyrol-Boc) mit einem Boc-Grad von mehr als 98%, zugegeben und die Mischung homogenisiert. Mit dem so erhaltenen schwarz pigmentierten Photoresist werden homogene Schichten auf der inneren Bildschirmseite einer Farbbildröhre mit einer Schichtdicke von 1,5 µm hergestellt. Die Schichten werden 1 min bei 60°C getrocknet, anschließend erfolgt die Belichtung mit einer Quecksilberhöchstdrucklampe (HBO 500) bei 2 - 5 mJ/cm². Die belichteten Schichten werden mit 60° heißem Wasser entwickelt. Anschließend werden die beschichteten Substrate trocken geschleudert. Es ist wichtig, daß unter Prozeßbedingungen die Positiv-Photoresist-Zusammensetzung regelmäßig homogenisiert wird, um ein Absetzen der suspendierten Teilchen zu verhindern.

### Beispiel 4

3,56 kg Polyvinylpyrrolidon (K90) werden in 50 l Wasser unter sehr starkem Rühren gelöst. Anschließend werden 0,75 kg Diazidostilbendisulfonsäure (DAS) hinzugegeben. Ein pH-Wert von 7,5 wird mit Hilfe von Natronlauge eingestellt. Das Gemisch wird nun unter starkem Rühren mit einern Graphitsuspension versetzt. Nach 48 Stunden wird der schwarz-pigmentierte Positiv-Photoresist im Ultraschallbad homogenisiert. Auf der inneren Bildschirmseite einer Farbbildröhre werden Schichten mit einer Dicke von 1,2 µm erzeugt. Mit einer Quecksilberhöchstdrucklampe (HBO 500) erfolgt die Belichtung bei 2 - 5 mJ/cm².
Entwickelt wird 35 sec in 60°C heißem Wasser. Anschließend wird das strukturierte Substrat trockengeschleudert.

### Beispiel 5

50 kg einer Graphitsuspension werden unter Rühren zu 50 kg eines handelsüblichen Photoresistes vom Typ NONCHRON gegeben. Nach 48 Stunden wird das Gemisch in einem Ultraschallbad aufgerührt. Mit dem so erhaltenen schwarz-pigmentierten Positiv-Photoresist werden homogene Schichten mit einer Dicke von 1 µm auf der inneren Bildschirmseite einer Farbbildröhre erzeugt. Die Schichten werden 1 min bei 60°C getrocknet, anschließend erfolgt 15 s die Belichtung mit einer Quecksilberhöchstdrucklampe (HBO 500) bei 2 - 5 mJ/cm². Die belichteten Bildschirme werden 35 sec in 60°C heißem Wasser entwickelt. Anschließend wird das strukturierte Substrat trockengeschleudert.

### Beispiel 6

15,0 g des p- Diazonium-diphenylamin-Harzes der Formel A 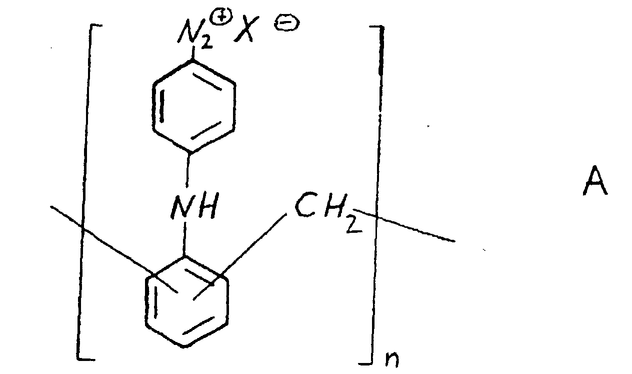 mit X=[ZnCl₃]⁻ und n = 7...12 werden in 200 ml Wasser gelöst. Das Gemisch wird unter starkem Rühren mit 250 ml einer 10 Gew.%igen Graphitsuspension versetzt. Nach 12 Stunden intensivem Rühren wird die Suspension 20 min. einer Turrax-Homogenisierung unterzogen (10.000 min⁻¹). Durch spin coating des schwarzpigmentierten Resistes werden 1,0 bis 1,5 µm dicke Schichten auf Glas erzeugt. Mit einer Quecksilberhöchstdrucklampe (HBO 500) erfolgt die Belichtung bei 2 - 5 mJ/cm². Entwickelt wird 10 s in 40°C warmen Wasser. Das strukturierte Glassubstrat wird getrocknet.

### Beispiel 7

10g des p-Diazonium-diphenylamin-Harzes der Formel A mit X=[ZnCl₃]⁻ und n= 7...12, und 5g Polyvinylpyrrolidon (K90) werden in 200 ml Wasser gelöst. Das Gemisch wird unter starkem Rühren mit 250 ml einer 10 Gew.%igen Graphitsuspension versetzt. Nach 12 Stunden intensivem Rühren wird die Suspension 20 min. einer Turrax-Homogenisierung unterzogen (10.000 min⁻¹). Durch spin coating des schwarzpigmentierten Resistes werden 1,0 bis 1,5 µm dicke Schichten auf Glas erzeugt. Mit einer Quecksilberhöchstdrucklampe (HBO 500) erfolgt die Belichtung bei 2 - 5 mJ/cm². Entwickelt wird 10 s in 40°C warmen Wasser. Die strukturierten Glassubstrate werden getrocknet.
Auf die, wie in den Beispielen 1 bis 7 beschrieben, hergestellten Matrixstrukturen werden Schutzschichten aufgebracht.

### Beispiel 8

Zu 150g demineralisiertem Wasser werden 2,1 g PVA-Moviol 40-88 Lösung 8,5 Gew%ig unter Rühren zugegeben. Nach dem Verrühren der PVA-Lösung werden 5 ml einer 1 Gew.%igen Ammoniumdichromat (ADC)-Lösung eingerührt. Von einer frisch bereiteten Lösung aus 1,7 g Ethylsilikat in 100 ml demineralisiertem Wasser werden 1 ml zu dieser PVA/ADC Lösung und anschließend 50 ml demineralisiertes Wasser hinzugegeben und 15 min gerührt. Diese Vorbeschichtungslösung wird auf die mit Wasser vorbenetzte Matrixstruktur gegeben, abgeschleudert und getrocknet. Bei 0,5 - 3 mJ/cm² UV-Licht wird diese Vorbeschichtung photogehärtet.

### Beispiel 9

Durch Lösen von Polyvinylpyrrolidon K90 (PVP) in demineralisiertem Wasser wird eine 6 Gew.%ige Lösung hergestellt. Durch Lösen von Diazidostilbendisulfonsäure -Dinatriumsalz (DAS) in demineralisiertes Wasser wird eine 3 Gew.%ige Lösung hergestellt.
Zur Herstellung einer Vorbeschichtungslösung werden
37g PVP Lösung (6 Gew.%)
7 g DAS Lösung (3 Gew.%)
63 g demineralisiertes Wasser
miteinander 30 min verrührt und anschließend unter Rühren 900 ml demineralisiertes Wasser zugegeben.
Dann werden 10 ml einer 1,7 Gew.%igen Ethylsilikat-Lösung zugegeben und weitere 15 min gerührt.
Diese Vorbeschichtungslösung wird auf die mit Wasser vorbenetzte Matrixstruktur gegeben, abgeschleudert und getrocknet.
Bei 0,5 - 5 mJ/cm² UV-Licht wird diese Vorbeschichtung photogehärtet.

## Patentansprüche

1. Black-Matrix in Farbbildröhren, bestehend aus einer Schicht einer lichtabsorbierenden Matrix, die herstellbar ist aus einer Positiv-Photoresist-Zusammensetzung, die aus einer Suspension, die
- eine oder mehrere Verbindungen, die durch Lichteinwirkung mittelbar oder unmittelbar gasförmige Verbindungen, N₂ oder O₂ freisetzen,
- ein schwarzes Pigment
und
- suspensionsstabilisierende, benetzungsfördernde und/oder haftvermittelnde Zusätze enthält,
besteht,
und
einer nach Belichtung, Entwicklung und Trocknung auf diese Schicht aufgebrachten photogehärteten wasserunlöslichen Schutzschicht aus
einem Mittel zum Schutz der lichtabsorbierenden Matrix, herstellbar aus einer Negativ-Photoresist - Zusammensetzung, bestehend aus
- einem wasserlöslichen organischen Polymer
- einer vernetzenden, aktinischen Komponente
- einem Alkylsilikat und
- Wasser,
wobei das Mittel einen pH-Wert zwischen 6 und 7,5 aufweist.

2. Black Matrix nach Anspruch 1,
**dadurch gekennzeichnet,**
**daß** die Verbindungen, die durch Lichteinwirkung gasförmige Verbindungen freisetzen, in ein Positiv-Relief überführbar sind.

3. Black Matrix nach Anspruch 1 oder 2,
**dadurch gekennzeichnet,**
**daß** die Gase freisetzenden Verbindungen lichtempfindliche Polymere oder Polymere in Kombination mit lichtempfindlichen Verbindungen sind.

4. Black Matrix nach einem der Ansprüche 1 bis 3,
**dadurch gekennzeichnet,**
**daß** die freigesetzten Gase CO₂, Aldehyde und/oder Kohlenwasserstoffe sind.

5. Black Matrix nach Anspruch 4,
**dadurch gekennzeichnet,**
**daß** die Stickstoff freisetzenden Verbindungen Azide, Bisazide, Diazide, Azo- und Diazoverbindungen, Heterocyclen mit mindestens zwei benachbarten Stickstoffatomen, Diazirine und/oder Diazoniumsalze sind.

6. Black Matrix nach Anspruch 5,
**dadurch gekennzeichnet,**
**daß** die Kohlendioxid freisetzenden Verbindungen Oxazolone, Dioxazolone, Carbonpersäuren oder deren Ester, Diacylperoxide, photodecarboxylierbare Carbonsäuren, Kohlensäureester und/oder -derivate sind.

7. Black Matrix nach Anspruch 1,
**dadurch gekennzeichnet,**
**daß** die Sauerstoff freisetzenden Verbindungen organische Hydroperoxide, organische Peroxide, Dioxetane und/oder Ozonide sind.

8. Black Matrix nach Anspruch 4,
**dadurch gekennzeichnet,**
**daß** die Aldehyd freisetzenden Verbindungen Polymethylene oder entsprechende Copolymere oder Co-Kondensate sind.

9. Black Matrix nach einem der Ansprüche 1 bis 8,
**dadurch gekennzeichnet,**
**daß** CO₂ und Kohlenwasserstoff freisetzenden Verbindungen tert-Butoxycarbonyl-substituierte, polymere Phenole oder Phenolharze sind.

10. Black Matrix nach einem der Ansprüche 1 bis 9,
**dadurch gekennzeichnet,**
**daß** die Verbindungen, die durch Lichteinwirkung mittelbar oder unmittelbar gasförmige Verbindungen freisetzen, filmbildende Eigenschaften aufweisen.

11. Black Matrix nach einem der Ansprüche 1 bis 9,
**dadurch gekennzeichnet,**
**daß** zusätzlich filmbildende Polymere oder Polymerdispersionen enthalten sind.

12. Black Matrix nach einem der Ansprüche 1 bis 11,
**dadurch gekennzeichnet,**
**daß** als Suspensionsmittel Wasser und/oder organische Lösungsmittel enthalten sind.

13. Black Matrix nach einem der Ansprüche 1 bis 4 und 10, bei welcher die Positiv-Photoresist-Zusammensetzung aus einer wäßrigen Suspension, die
- hydrophobiertes Polyhydroxystyrol
- schwarzes Pigment
- einen zwischen 250 und 450 nm absorbierenden Oniumsalz-Photoinitiator
und
- suspensionsstabilisierende, benetzungsfördernde und/oder haftvermittelnde Zusätze
enthält, besteht.

14. Black Matrix nach Anspruch 13,
**dadurch gekennzeichnet,**
- **daß** 4 bis 15 Gewichts-% hydrophobiertes Polyhydroxystyrol mit einem Hydrophobierungsgrad von mindestens 75%
- 1,5 bis 8 Gewichts-% schwarzes Pigment
- mindestens 0,01 Gewichts-% eines zwischen 250 und 450 nm absorbierendes Oniumsalz-Photoinitiator
und
- suspensionstabilisierende, benetzungsfördernde und/oder haftvermittelnde Zusätze
in einem wäßrigen Dispersionsmittel enthalten sind.

15. Black Matrix nach Anspruch 13 oder 14,
**dadurch gekennzeichnet,**
**daß** als Oniumsalz-Photoinitiator Diaryliodoniumund/oder Triarylsulfoniumsalze enthalten sind.

16. Black Matrix nach einem der Ansprüche 13 bis 15,
**dadurch gekennzeichnet,**
**daß** als hydrophobiertes Polyhydroxystyrol Alkoxycarbonyl-polyhydroxystyrol oder Aryloxycarbonylpolyhydroxystyrol enthalten ist.

17. Black Matrix nach einem der Ansprüche 13 bis 16,
**dadurch gekennzeichnet,**
**daß** als hydrophobiertes Polyhydroxystyrol tert.-Butyloxycarbonyl-polyhydroxystyrol enthalten ist.

18. Black Matrix nach einem der Ansprüche 13 bis 17,
**dadurch gekennzeichnet,**
**daß** tert.-Butyloxycarbonyl-poly-(p-hydroxy)-styrol enthalten ist.

19. Black Matrix nach einem der Ansprüche 13 bis 18,
**dadurch gekennzeichnet,**
**daß** das Polyhydroxystyrol einen Alkylierungsgrad von 0-100% aufweist.

20. Black Matrix nach einem der Ansprüche 13 bis 19,
**dadurch gekennzeichnet,**
**daß** das Polyhydroxystyrol einen Hydrophilisierungsgrad von 0 - 50% aufweist.

21. Black Matrix nach einem der Ansprüche 1 bis 20,
**dadurch gekennzeichnet,**
**daß** das schwarze Pigment Metall, Metalloxid, Metallmischoxid und/oder Metallsalz ist.

22. Black Matrix nach einem der Ansprüche 1 bis 21,
**dadurch gekennzeichnet,**
**daß** das schwarze Pigment Graphit und/oder Ruß ist.

23. Black Matrix nach einem der Ansprüche 1 bis 22,
**dadurch gekennzeichnet,**
**daß** das schwarze Pigment eine Teilchengröße von 0,05 bis 10 µm aufweist.

24. Black Matrix nach einem der Ansprüche 12 bis 23,
**dadurch gekennzeichnet,**
**daß** der pH-Wert der wäßrigen Suspension 4,5 bis 9 beträgt.

25. Black Matrix nach einem der Ansprüche 12 bis 24,
**dadurch gekennzeichnet,**
**daß** der pH-Wert der wäßrigen Suspension 7 ± 1 beträgt.

26. Black Matrix nach einem der Ansprüche 1 bis 25,
**dadurch gekennzeichnet,**
**daß** das Mittel aus
- einem wasserlöslichen, organischen Polymer
- einem Chromsalz
- einem Alkylsilikat und
- Wasser
besteht,
wobei das Mittel einen pH-Wert zwischen 6 und 7,5 aufweist.

27. Black Matrix nach einem der Ansprüche 1 oder 26,
**dadurch gekennzeichnet,**
**daß** als Polymer Polyvinylalkohol, Polyvinylpyrrolidon, Polyamide und/oder Polyimide enthalten ist.

28. Black Matrix nach einem der Ansprüche 1 bis 27,
**dadurch gekennzeichnet,**
**daß** als aktinische Komponente Alkali- und/oder Ammoniumdichromat und/oder Diazidostilbendisulfonsäure-Dinatriumsalz enthalten ist.

29. Black Matrix nach einem der Ansprüche 1 bis 28,
**dadurch gekennzeichnet,**
**daß** als Alkylsilikat Ethylsilikat enthalten ist.

30. Black Matrix nach einem der Ansprüche 1 bis 29,
**dadurch gekennzeichnet,**
**daß** der pH-Wert des Mittels 6,3 - 7,0 beträgt.

31. Black Matrix nach einem der Ansprüche 1 bis 30,
**dadurch gekennzeichnet,**
**daß** das Mittel aus Wasser besteht,
das enthält
0.050 - 0,50 % eines wasserlöslichen, organischen Polymers
0,010 - 0,050% vernetzende, aktinische Komponente und
0,002 - 0,020% Alkylsilikat.

32. Black Matrix nach einem der Ansprüche 1 bis 31,
**dadurch gekennzeichnet,**
**daß** das Mittel im Bereich 300 bis 450 nm photovernetzbar ist.

33. Black Matrix nach einem der Ansprüche 1 bis 32,
**dadurch gekennzeichnet,**
**daß** schichtstabilisierende Substanzen wie Binder enthalten sind.

34. Black Matrix nach einem der Ansprüche 1 bis 33,
**dadurch gekennzeichnet,**
**daß** die schichtstabilisierenden Substanzen lösliche, anorganische oder organische Polymere sind.

35. Verfahren zur Herstellung einer
Black-Matrix in Farbbildröhren nach Anspruch 1, durch Beschichten der inneren Bildschirmfläche mit einer Schicht einer lichtabsorbierenden Matrix herstellbar aus einer Photoresist-Zusammensetzung, wobei
- die innere Bildschirmfläche mit einer Positiv-Photoresist-Zusammensetzung bestehend aus einer Suspension, die eine oder mehrere Verbindungen, die durch Lichteinwirkung mittelbar oder unmittelbar gasförmige Verbindungen, N₂ oder O₂ freisetzen, ein schwarzes Pigment und suspensionsstabilisierende, benetzungsfördernde und/oder haftvermittelnde Zusätze enthält, besteht, beschichtet wird,
- die Schicht anschließend getrocknet wird,
- die Schicht zur Strukturbelichtung mit Licht einer Wellenlänge zwischen 250 und 450 nm belichtet wird,
- die Schicht mit Wasser, das eine Temperatur von 40 bis 80°C aufweist, entwickelt wird,
- die entstandene Matrix getrocknet wird und
- die gesamte Matrix mit einer nach Belichtung, Entwicklung und Trocknung auf diese Schicht aufgebrachten photogehärteten wasserunlöslichen Schutzschicht aus einem Mittel zum Schutz der lichtabsorbierenden Matrix, herstellbar aus einer Negativ-Photoresist-Zusammensetzung, bestehend aus
- einem wasserlöslichen organischen Polymer
- einer vernetzenden, aktinischen Komponente
- einem Alkylsilikat und
- Wasser,
wobei das Mittel einen pH-Wert zwischen 6 und 7,5 aufweist, Schutzschicht überzogen wird.

36. Verfahren nach Anspruch 35,
**dadurch gekennzeichnet,**
**daß** vor der Strukturbelichtung eine Vorbelichtung der gesamten Schicht erfolgt.

37. Verfahren nach Anspruch 35 oder 36,
**dadurch gekennzeichnet,**
**daß** das Entwicklungswasser einen pH-Wert von 7 - 12 aufweist.

38. Verfahren nach einem der Ansprüche 35 bis 37,
**dadurch gekennzeichnet,**
**daß** vor dem Entwicklungsschritt eine Temperaturbehandlung zwischen 40 bis 150°C durchgeführt wird und anschließend eine Entwicklung mit Wasser erfolgt.

39. Black Matrix nach einem der Ansprüche 1 bis 25, 33, 34,
**dadurch gekennzeichnet,**
**daß** die Suspension aus
- Polyvinylpyrrolidon,
- schwarzes Pigment,
- 4,4'-Diazidostilben-2,2'-disulfonsäure-Dinatriumsalz und
- Tenside
besteht.

40. Black Matrix nach einem der Ansprüche 1 bis 25, 33, 34, und 39,
**dadurch gekennzeichnet,**
**daß**
- 1 bis 8 Gewichts-% Polyvinylpyrrolidon mit einem K-Wert von 60 bis 120,
- 1 bis 8 Gewichts-% schwarzes Pigment,
- 0,1 bis 3 Gewichts-% 4,4'-Diazidostilben-2,2'disulfonsäure-Dinatriumsalz
und
- bis zu 2 Gewichts-% Zusätze
in einem wäßrigen Dispersionsmittel enthalten sind.

41. Black Matrix nach einem der Ansprüche 1 bis 25, 33, 34, 39 oder 40,
**dadurch gekennzeichnet,**
**daß** das schwarze Pigment vor dem Vermischen mit dem Resist als Feststoff oder als Suspension vorliegt, die zusätzlich bis zu 10 Gewichts-% polymere Binder enthält.

42. Black Matrix nach einem der Ansprüche 1 bis 25, 33, 34 oder 39 bis 41,
**dadurch gekennzeichnet,**
**daß** als Tenside Fettsäure-Salze enthalten sind.

## Claims

1. A black matrix in colour picture tubes, consisting of a layer of a light-absorbing matrix, which may be produced from a positive photoresist composition consisting of a suspension which contains
- one or more compounds which indirectly or directly release gaseous compounds, N₂ or O₂ on exposure to light,
- a black pigment,
and
- suspension-stabilizing, wetting-promoting and/or adhesion-promoting additives;
and
a photo-hardened water-insoluble protective layer deposited on said layer after exposure, development and drying using an agent for protecting the light-absorbing matrix, which may be produced from a negative photoresist composition consisting of
- a water-soluble organic polymer,
- a crosslinking actinic component,
- an alkyl silicate, and
- water,
said agent having a pH value of between 6 and 7.5.

2. A black matrix according to claim 1, **characterized in that** the compounds which release gaseous compounds on exposure to light can be transformed into a positive relief.

3. A black matrix according to claim 1 or 2, **characterized in that** the gas-releasing compounds are polymers or polymers in combination with photosensitive compounds.

4. A black matrix according to one of claims 1 to 3, **characterized in that** the released gases are CO₂, aldehydes and/or hydrocarbons.

5. A black matrix according to claim 4, **characterized in that** the nitrogen-releasing compounds are azides, bisazides, diazides, azo and diazo compounds, heterocycles having at least two adjacent nitrogen atoms, diazirines and/or diazonium salts.

6. A black matrix according to claim 5, **characterized in that** the compounds releasing carbon dioxide are oxazolones, dioxazolones, peroxycarboxylic acids or esters thereof, diacyl peroxides, photo-decarboxylatable carboxylic acids, carbonic esters and/or carbonic derivatives.

7. A black matrix according to claim 1, **characterized in that** the compounds releasing oxygen are organic hydroperoxides, organic peroxides, di-oxetanes and/or ozonides.

8. A black matrix according to claim 4, **characterized in that** the compounds releasing aldehyde are polymethylenes or corresponding copolymers or co-condensates.

9. A black matrix according to one of claims 1 to 8, **characterized in that** the compounds releasing CO₂ and hydrocarbons are tert.-butoxycarbonyl-substituted, polymeric phenols or phenol resins.

10. A black matrix according to one of claims 1 to 9, **characterized in that** the compounds which indirectly or directly release gaseous compounds on exposure to light have film-forming properties.

11. A black matrix according to one of claims 1 to 9, **characterized in that** film-forming polymers or polymer dispersions are contained in addition.

12. A black matrix according to one of claims 1 to 11, **characterized in that** water and/or organic solvents are contained as suspending agents.

13. A black matrix according to one of claims 1 to 4 and 10, with which the positive photoresist composition consists of an aqueous suspension containing
- hydrophobized polyhydroxystyrene,
- a black pigment,
- an onium salt photoinitiator absorbing between 250 and 450 nm,
and
- suspension-stabilizing, wetting-promoting and/or adhesion-promoting additives.

14. A black matrix according to claim 13,
**characterized in that**
- from 4 to 15% by weight of hydrophobized polyhydroxystyrene having a hydrophobization level of at least 75%,
- from 1.5 to 8% by weight of a black pigment,
- at least 0.01% by weight of an onium salt photoinitiator absorbing between 250 and 450 nm,
and
- suspension-stabilizing, wetting-promoting and/or adhesion-promoting additives
are contained in an aqueous dispersing agent.

15. A black matrix according to claim 13 or 14, **characterized in that** diaryliodonium and/or triarylsulfonium salts are contained as onium salt photoinitiator.

16. A black matrix according to one of claims 13 to 15, **characterized in that** alkoxycarbonylpolyhydroxystyrene or aryloxycarbonylpolyhydroxystyrene is contained as hydrophobized polyhydroxystyrene.

17. A black matrix according to one of claims 13 to 16, **characterized in that** tert.-butoxycarbonylpolyhydroxystyrene is contained as hydrophobized polyhydroxystyrene.

18. A black matrix according to one of claims 13 to 17, **characterized in that** tert.-butoxycarbonylpoly(p-hydroxystyrene) is contained.

19. A black matrix according to one of claims 13 to 18, **characterized in that** the polyhydroxystyrene has an alkylation level of 0-100%.

20. A black matrix according to one of claims 13 to 19, **characterized in that** the polyhydroxystyrene has a hydrophilization level of 0-50%.

21. A black matrix according to one of claims 1 to 20, **characterized in that** a metal, metal oxide, metal mixed oxide and/or metal salt is contained as black pigment.

22. A black matrix according to one of claims 1 to 21, **characterized in that** the black pigment is graphite and/or carbon black.

23. A black matrix according to one of claims 1 to 22, **characterized in that** the black pigment has a particle size of from 0.05 to 10 µm.

24. A black matrix according to one of claims 12 to 23, **characterized in that** the pH value of the aqueous suspension is from 4.5 to 9.

25. A black matrix according to one of claims 12 to 24, **characterized in that** the pH value of the aqueous suspension is 7 ± 1.

26. A black matrix according to one of claims 1 to 25, **characterized in that** the agent consists of
- a water-soluble, organic polymer,
- a chromium salt,
- an alkyl silicate, and
- water,
wherein the agent has a pH value of between 6 and 7.5.

27. A black matrix according to one of claims 1 or 26, **characterized in that** polyvinyalcohol, polyvinylpyrrolidone, polyamides and/or polyimides are contained as polymer.

28. A black matrix according to one of claims 1 to 27, **characterized in that** alkali and/or ammonium dichromate and/or diazidostilbenedisulfonic acid disodium salt are contained as actinic component.

29. A black matrix according to one of claims 1 to 28, **characterized in that** ethyl silicate is contained as alkyl silicate.

30. A black matrix according to one of claims 1 to 29, **characterized in that** the pH value of the agent is from 6.3 to 7.0.

31. A black matrix according to one of claims 1 to 30, **characterized in that** the agent consists of water containing
0.050 - 0.50% of a water-soluble, organic polymer,
0.010 - 0.050% of a crosslinking, actinic component, and
0.002 - 0.020% of an alkyl silicate.

32. A black matrix according to one of claims 1 to 31, **characterized in that** the agent is photocrosslinkable in the range of 300 to 450 nm.

33. A black matrix according to one of claims 1 to 32, **characterized in that** layer-stabilizing substances such as binders are contained.

34. A black matrix according to one of claims 1 to 33, **characterized in that** the layer-stabilizing substances are soluble inorganic or organic polymers.

35. A process for producing a black matrix in colour picture tubes according to claim 1 by coating the interior screen surface with a layer of a light-absorbing matrix, which may be produced from a photoresist composition, whereby
- the interior screen surface is coated with a positive photoresist composition consisting of a suspension which contains one or more compounds which indirectly or directly release gaseous compounds, N₂ or O₂ on exposure to light, a black pigment and suspension-stabilizing, wetting-promoting and/or adhesion-promoting additives,
- the layer is dried subsequently,
- for structural exposure, the layer is exposed to light having a wavelength of between 250 and 450 nm,
- the layer is developed using water having a temperature of from 40 to 80°C,
- the formed matrix is dried, and
- the entire matrix is coated with a a photo-hardened water-insoluble protective layer deposited on said layer after exposure, development and drying using an agent for protecting the light-absorbing matrix, which may be produced from a negative photoresist composition consisting of
- a water-soluble organic polymer,
- a crosslinking actinic component,
- an alkyl silicate, and
- water,
said agent having a pH value of between 6 and 7.5.

36. The process according to claim 35, **characterized in that** a pre-exposure of the entire layer is effected prior to said structural exposure.

37. The process according to claim 35 or 36, **characterized in that** the developing water has a pH value of from 7 to 12.

38. The process according to one of claims 35 to 37, **characterized in that** a temperature treatment of between 40 to 150°C is carried out prior to the developing step and subsequently, development is effected using water.

39. A black matrix according to one of claims 1 to 25, 33, 34, **characterized in that** the suspension consists of
- polyvinylpyrrolidone,
- a black pigment,
- 4,4'-diazidostilbene-2,2'-disulfonic acid disodium salt,
and
- surfactants.

40. A black matrix according to one of claims 1 to 25, 33, 34, and 39, **characterized in that**
- from 1 to 8% by weight of polyvinylpyrrolidone having a K value of from 60 to 120,
- from 1 to 8% by weight of a black pigment,
- from 0.1 to 3% by weight of 4,4'-diazidostilbene-2,2'-disulfonic acid disodium salt, and
- up to 2% by weight of additives
are contained in an aqueous dispersing agent.

41. A black matrix according to one of claims 1 to 25, 33, 34, 39 or 40, **characterized in that** prior to mixing with the resist, the black pigment is in the form of a solid or a suspension additionally containing up to 10% by weight of polymeric binders.

42. A black matrix according to one of claims 1 to 25, 33, 34 or 39 to 41, **characterized in that** salts of fatty acids are contained as surfactants.

## Revendications

1. Matrice noire de tubes à image en couleur, consistant en une couche d'une matrice absorbant la lumière, pouvant être produite à partir d'un composé photorésistant positif, lequel consiste en une suspension contenant
- un ou plusieurs composés libérant directement ou indirectement des composés gazeux, N₂ ou O₂, sous l'effet de la lumière,
- un pigment noir
et
- des additifs stabilisateurs de suspension, favorisant le mouillage et/ou agents adhésifs,
et
une couche protectrice photodurcie, insoluble dans l'eau, appliquée sur ladite couche après exposition, développement et séchage, formée à partir d'un agent de protection de la matrice absorbant la lumière pouvant être produit à partir d'un composé photorésistant négatif, consistant en
- un polymère organique soluble dans l'eau
- un composant actinique réticulant
- un silicate d'alkyle
- et en eau,
ledit agent présentant une valeur de pH comprise entre 6 et 7,5.

2. Matrice noire selon revendication 1,
**caractérisée en ce que**
les composés libérant des composés gazeux sous l'effet de la lumière sont transformables en un relief positif.

3. Matrice noire selon revendication 1 ou 2,
**caractérisée en ce que**
les composés libérant les gaz sont des polymères sensibles à la lumière ou des polymères combinés à des composés sensibles à la lumière.

4. Matrice noire selon l'une des revendication 1 à 3,
**caractérisée en ce que**
les gaz libérés sont du CO₂, des aldéhydes et/ou des hydrocarbures.

5. Matrice noire selon revendication 4,
**caractérisée en ce que**
les composés libérant de l'azote sont des azotures, bisazotures, diazotures, composés azotés et diazotés, hétérocycles présentant au moins deux atomes d'azote voisins, des diazirines et/ou des sels de diazonium.

6. Matrice noire selon revendication 5,
**caractérisée en ce que**
les composés libérant du dioxyde de carbone sont des oxazoles, dioxazoles, des peracides de carbone ou leurs esters, des peroxydes de diacyle, des acides carboxyliques photodécarboxylisables et/ou des dérivés.

7. Matrice noire selon revendication 1,
**caractérisée en ce que**
les composés libérant de l'oxygène sont des hydroperoxydes organiques, des peroxydes organiques, des dioxétanes et/ou des ozonides.

8. Matrice noire selon revendication 4,
**caractérisée en ce que**
les composés libérant de l'aldéhyde sont des polyméthylènes, des copolymères correspondants ou des co-condensats.

9. Matrice noire selon l'une des revendications 1 à 8,
**caractérisée en ce que**
les composés libérant du CO₂ et de l'hydrocarbure sont des phénols polymères, tert-butoxycarbonyl substitués, ou des résines phénoliques.

10. Matrice noire selon l'une des revendications 1 à 9,
**caractérisée en ce que**
les composés libérant directement ou indirectement des composés gazeux sous l'effet de la lumière présentent des propriétés filmogènes.

11. Matrice noire selon l'une des revendications 1 à 9,
**caractérisée en ce que**
des polymères filmogènes ou des dispersions polymériques sont contenus en sus.

12. Matrice noire selon l'une des revendications 1 à 11,
**caractérisée en ce que**
de l'eau et/ou des solvants organiques sont contenus en tant qu'agents de suspension.

13. Matrice noire selon l'une des revendications 1 à 4 et 10, où le composé photorésistant positif consiste en une suspension aqueuse contenant
- du polyhydroxystyrène hydrofugé
- du pigment noir
- un photo-initateur à sel d'onium absorbant entre 250 et 450 nm
et
- des additifs stabilisateurs de suspension, favorisant le mouillage et/ou agents adhésifs.

14. Matrice noire selon revendication 13,
**caractérisée en ce que**
- 4 à 15 % en poids du polyhydroxystyrène hydrofugé avec un degré d'hydrofugation de 75 % au moins
- 1, 5 à 8 % en poids du pigment noir
- au moins 0,01 % en poids d'un photo-initateur à sel d'onium absorbant entre 250 et 450 nm
et
- des additifs stabilisateurs de suspension, favorisant le mouillage et/ou agents adhésifs
sont contenus dans un agent de dispersion aqueux.

15. Matrice noire selon revendication 13 ou 14,
**caractérisée en ce que**
des sels de diaryliodonium et/ou de triarylsulfonium sont contenus en tant que photo-initateur à sel d'onium.

16. Matrice noire selon l'une des revendications 13 à 15,
**caractérisée en ce que**
de l'alkoxycarbonyl-polyhydroxystyrène ou de l'aryloxycarbonyl-polyhydroxystyrène est contenu en tant que polyhydroxystyrène hydrofugé.

17. Matrice noire selon l'une des revendications 13 à 16,
**caractérisée en ce que**
du tert.-butyloxycarbonyl-polyhydroxystyrène est contenu en tant que polyhydroxystyrène hydrofugé.

18. Matrice noire selon l'une des revendications 13 à 17,
**caractérisée en ce que**
du tert.-butyloxycarbonyl-poly-(p-hydroxy)-styrène est contenu.

19. Matrice noire selon l'une des revendications 13 à 18,
**caractérisée en ce que**
le polyhydroxystyrène présente un degré d'alkylation de 0 à 100 %.

20. Matrice noire selon l'une des revendications 13 à 19,
**caractérisée en ce que**
le polyhydroxystyrène présente un degré d'hydrophilisation de 0 à 50 %.

21. Matrice noire selon l'une des revendications 1 à 20,
**caractérisée en ce que**
le pigment noir est du métal, de l'oxyde métallique, de l'oxyde mixte métallique et/ou du sel métallique.

22. Matrice noire selon l'une des revendications 1 à 21,
**caractérisée en ce que**
le pigment noir est du graphite et/ou du noir de carbone.

23. Matrice noire selon l'une des revendications 1 à 22,
**caractérisée en ce que**
le pigment noir présente une finesse de particule comprise entre 0,05 et 10 µm.

24. Matrice noire selon l'une des revendications 12 à 23,
**caractérisée en ce que**
la valeur de pH de la suspension aqueuse est comprise entre 4,5 à 9.

25. Matrice noire selon l'une des revendications 12 à 24,
**caractérisée en ce que**
la valeur de pH de la suspension aqueuse est de 7 ± 1.

26. Matrice noire selon l'une des revendications 1 à 25,
**caractérisée en ce que**
l'agent consiste en
- un polymère organique soluble dans l'eau
- un sel de chrome
- un silicate d'alkyle
- et en eau,
ledit agent présentant une valeur de pH comprise entre 6 et 7,5.

27. Matrice noire selon l'une des revendications 1 ou 26,
**caractérisée en ce que**
de l'alcool polyvinylique, de la polyvinylpyrrolidone, des polyamides et/ou des polyimides sont contenus en tant que polymère.

28. Matrice noire selon l'une des revendications 1 à 27,
**caractérisée en ce que**
du dichromate d'alcali et/ou d'ammonium et/ou du sel disodique d'acide diazidostilbènedisulfonique est contenu en tant que composant actinique.

29. Matrice noire selon l'une des revendications 1 à 28,
**caractérisée en ce que**
du silicate d'éthyle est contenu en tant que silicate d'alkyle.

30. Matrice noire selon l'une des revendications 1 à 29,
**caractérisée en ce que**
la valeur pH de l'agent est comprise entre 6,3 et 7,0.

31. Matrice noire selon l'une des revendications 1 à 30,
**caractérisée en ce que**
l'agent consiste en eau,
contenant
0,050 à 0,50 % d'un polymère organique soluble dans l'eau
0,010 à 0,050 % de composant actinique réticulant, et
0,002 à 0,020 % de silicate d'alkyle.

32. Matrice noire selon l'une des revendications 1 à 31,
**caractérisée en ce que**
l'agent est photoréticulable dans la plage de 300 à 450 nm.

33. Matrice noire selon l'une des revendications 1 à 32,
**caractérisée en ce que**
des substances stabilisatrices de couche telles que liants sont contenues.

34. Matrice noire selon l'une des revendications 1 à 33,
**caractérisée en ce que**
les substances stabilisatrices de couche sont des polymères solubles, organiques ou inorganiques.

35. Procédé pour la production d'une matrice noire de tubes à image en couleur selon revendication 1, par revêtement de la surface intérieure d'écran avec une couche d'une matrice absorbant la lumière pouvant être produite à partir d'un composé photorésistant, où
- la surface intérieure d'écran est revêtue d'un composé photorésistant positif consistant en une suspension contenant un ou plusieurs composés libérant directement ou indirectement des composés gazeux, N₂ ou O₂, sous l'effet de la lumière, un pigment noir et des additifs stabilisateurs de suspension, favorisant le mouillage et/ ou agents adhésifs,
- la couche est ensuite séchée,
- la couche est exposée pour exposition structurelle à une lumière d'une longueur d'onde comprise entre 250 et 450 nm,
- la couche est développée avec de l'eau présentant une température comprise entre 40 et 80 °C,
- la matrice créée est séchée
- et toute la matrice est revêtue par une couche protectrice photodurcie, insoluble dans l'eau, appliquée sur ladite couche après exposition, développement et séchage, formée à partir d'un agent de protection de la matrice absorbant la lumière pouvant être produit à partir d'un composé photorésistant négatif, consistant en
- un polymère organique soluble dans l'eau
- un composant actinique réticulant
- un silicate d'alkyle
- et en eau,
ledit agent présentant une valeur de pH comprise entre 6 et 7,5.

36. Procédé selon revendication 35,
**caractérisé en ce qu'**
une pré-exposition de toute la couche est effectuée avant l'exposition structurelle.

37. Procédé selon revendication 35 ou 36,
**caractérisé en ce que**
l'eau de développement présente une valeur pH comprise entre 7 et 12.

38. Procédé selon revendication 35 à 37,
**caractérisé en ce qu'**
un traitement par température comprise entre 40 et 150 °C est appliqué avant la phase de développement, un développement à l'eau étant effectué ensuite.

39. Matrice noire selon l'une des revendications 1 à 25, 33, 34,
**caractérisée en ce que**
la suspension consiste en
- polyvinylpyrrolidone,
- pigment noir,
- 4,4' - diazidostilbène - 2,2' - acide disulfonique - sel disodique
et
- agents tensioactifs.

40. Matrice noire selon l'une des revendications 1 à 25, 33, 34, et 39,
**caractérisée en ce que**
- 1 à 8 % en poids de la polyvinylpyrrolidone avec une valeur K comprise entre 60 et 120,
- 1 à 8 % en poids du pigment noir
- 0,1 à 3 % en poids du 4,4' - diazidostilbène - 2,2' - acide disulfonique - sel disodique et
- jusqu'à 2 % en poids d'additifs sont contenus dans un agent de dispersion aqueux.

41. Matrice noire selon l'une des revendications 1 à 25, 33, 34, 39 ou 40,
**caractérisée en ce que**
le pigment noir se présente avant mélange avec la matière. de protection comme matière solide ou comme suspension contenant jusqu'à 10 % en poids de liants polymères.

42. Matrice noire selon l'une des revendications 1 à 25, 33, 34, ou 39 à 41,
**caractérisée en ce que**
des sels d'acides gras sont contenus comme agents tensioactifs.
